# EUROPEAN PATENT SPECIFICATION

(11) **EP 4 655 823 B1**
(45) Date of publication and mention of the grant of the patent: **11.11.2026**
(21) Application number: 24700323.9
(22) Date of filing: 16.01.2024
(51) Int. Cl.: H10F 39/12, H10F 39/00

(54) **IMAGING SENSOR COMPRISING QUANTUM DOTS, SENSOR SYSTEM AND METHOD FOR MANUFACTURING AN IMAGING SENSOR**
ABBILDUNGSSENSOR MIT QUANTENPUNKTEN, SENSORSYSTEM UND VERFAHREN ZUR HERSTELLUNG EINES ABBILDUNGSSENSORS
CAPTEUR D'IMAGERIE COMPRENANT DES POINTS QUANTIQUES, SYSTÈME DE CAPTEUR ET PROCÉDÉ DE FABRICATION D'UN CAPTEUR D'IMAGERIE

(30) Priority: 24.01.2023 EP 23152976
(43) Date of publication of application: 03.12.2025
(73) Proprietor: Ludwig-Maximilians-Universität München, 80539 München (DE)
(72) Inventor: AMIN, Amir Y., 80539 München (DE)
(74) Representative: Prinz & Partner mbB
(86) International application number: PCT/EP2024/050896
(87) International publication number: WO 2024/156541

(56) References cited:
- EP-A1- 3 979 333
- US-A1- 2005 205 879
- US-A1- 2008 315 339
- US-A1- 2018 342 647

## Description

The invention relates to an imaging sensor comprising light-sensitive detector elements with quantum dots, a sensor system comprising such an imaging sensor and a method for manufacturing an imaging sensor.

In spectroscopy applications, a sample is irradiated with light, i.e. electromagnetic radiation of a given range of wavelengths defining a light spectrum. By interaction of the sample with the light, e.g. by absorption, the light spectrum is characteristically changed, such that information about the sample can be derived from the changed light spectrum.

A core component of any given spectroscopy setup is the imaging sensor which is used to detect the light after interaction with the sample. Typically, imaging sensors comprise a multitude of small light-sensitive areas (also termed "pixels") spread along one or two axes of the imaging sensor. The signals obtained from each individual pixel is then used to assemble an overall image of the area of interest.

E.g., in NIR (near-infrared) applications, InGaAs-based multi-channel array detectors are used for detecting infrared light due to their high sensitivity to light in the NIR spectrum.

In a typical spectrometer, the light for detection is spread as a function of its wavelength by an optical element like a grating along at least one of the axes of the imaging sensor. Thus, the pixel at one end of the respective axis will be irradiated with light of a minimum wavelength, the neighboring pixel with light of a slightly higher wavelength, the next-neighboring pixel with light of an even slightly higher wavelength and so on until the pixel at the other end of the respective axis will be irradiated with light of a maximum wavelength.

Known imaging sensors suffer from limitations based on their performance and their spectral response, which can be expressed in terms of their responsivity. The responsivity measures an input-output gain of a given imaging sensor and is a ratio between the electrical output power and the optical input power. Here, the responsivity is expressed in terms of current responsivity Rᵢ which can be expressed by the following equation (1): ${R}_{i} = \frac{Δ I}{{P}_{in}} = \frac{q \left(\frac{η}{hν}\right) {τ}_{n}}{{τ}_{t}}$ (1) in which ΔI is the created output current, Pᵢₙ is the optical input power, q is the electron charge, η is the quantum efficiency (i.e., the conversion efficiency of photons to electrons), h is Planck's constant and v is the frequency of the respective light. The ratio τₙ/τₜ describes the photoconductive gain. In case this ratio is bigger than one, the responsivity is increased.

In commercially available imaging sensors based on InGaAs, the spectral response or responsivity is less than 1 A/W over considerable parts of the VIS and NIR spectrum. This directly influences the specific detectivity of the imaging sensor, which describes the smallest optical input which can be sensed by the detector, wherein the smallest optical input power (also called "noise equivalent power" P_{NEP}) can be described as P_{NEP} = Iₙₒᵢₛₑ/Rᵢ, wherein Iₙₒᵢₛₑ defines electrical noise which is a random variable resulting from stochastic or random processes associated with various particles.

In the last years, alternatives to InGaAs-based detector elements have been investigated, e.g. Bulk PbS NIR-sensitive materials, PbS quantum dots, combinations of graphene and PbS quantum dots and NIR sensitive polymers. However, none of these alternatives reach the same performance as InGaAs-based detector elements.

US 2008/315339 A1 shows a solid-state imaging device comprising a light-receiving portion formed in a semiconductor substrate, wherein in the light-receiving portion a photoelectric conversion of incoming light is carried out. The imaging device further comprises an optical filter layer in which quantum dots having substantially equal diameters are formed, wherein the quantum dots have higher refractive indexes than the refractive index of the optical filter layer.

EP 3 979 333 A1 discloses an optical sensor comprising a photoelectric conversion element and an optical member provided on a light-incident side with respect to the photoelectric conversion element. The optical sensor includes quantum dots with a maximum absorption wavelength in an infrared range having a wavelength of 800 nm or longer while the optical member is an infrared transmitting member having a high transmittance for light having a wavelength of 800 nm or longer and a low transmittance for light in a wavelength range of 400 to 650 nm.

From US 2005/205879 A1, a photoelectric converting film stack type solid-state image pickup device is known which comprises a semiconductor substrate, in which a signal read circuit is formed, and one or more photoelectric converting films stacked above each other in the direction of an incident light beam, wherein each of the photoelectric converting films comprises a quantum dot contributing to the photoelectric conversion and a material having a band gap larger than that of the quantum dot.

US 2018/342647 A1 describes quantum dots comprising a core quantum dot, a first semiconductor shell consisting of ZnS or ZnSe and a second semiconductor shell comprising a second semiconductor material different from the first semiconductor shell and comprising a group II to VI compound. The quantum dot can be part of an ink further including a liquid vehicle.

The object of the invention is to provide an imaging sensor with high responsivity, especially with a uniform responsivity over extended parts of the light spectrum.

The object of the invention is solved by an imaging sensor comprising a plurality of light-sensitive detector elements being arranged in an array structure, the detector elements comprising quantum dots, wherein the average diameter of the quantum dots of the detector elements increase along an array axis of the array structure such that each of the detector elements along the array axis has an absorption maximum at a different pre-determined wavelength. The quantum dots of a given detector element are part of a film structure of the given detector element comprising the quantum dots and an additive.

The invention is based on the idea to use a multitude of different sized quantum dots along the array structure of the imaging sensor such that at every point along the array axis quantum dots are used which are optimal for the light of the specific wavelength irradiated on the respective point of the imaging sensor along the array axis. Termed differently, the imaging sensor according to the invention uses selective quantum dots with a tuned size at selected positions along the array axis for increasing the quantum efficiency at each individual wavelength detectable by the imaging sensor, thereby optimizing the overall responsivity of the imaging sensor. This effect is based on the effect that quantum dots show an absorption maximum at a wavelength which is dependent on the size of the quantum dots.

The additive improves the long-term stability of the detector elements, especially by providing a barrier against environmental influences. Furthermore, the presence of the additive improves the surface structure of the quantum-dot comprising film of the detector element by suppressing crack formation and reducing surface roughness.

In contrast, in conventional InGaAs-based imaging sensors, the same type of InGaAs-based detector element is used at all pixels of the imaging sensor. Thus, wavelengths at which the respective kind of detector element has a low responsivity cannot be compensated for, leading to an overall suboptimal responsivity of the conventional imaging sensor.

The detector elements are also termed "pixels", wherein the totality of pixels define the picture obtained by the imaging sensor.

The detector elements are responsible for the conversion of incoming optical input power into electrical output power, as can be defined by the responsivity.

The average diameter of the quantum dots can be determined by taking a TEM-image of the respective detector element, measuring the individual quantum dot diameter throughout the detector element and calculating the average value of the measured individual quantum dot diameters.

The expression "increasing along an array axis of the array structure" especially means "continuously increasing along an array axis of the array structure". That is, in the sequence of detector elements along the respective array axis, the size of the quantum dots used in the respective detector elements especially are continuously increasing when following the sequence of the detector elements.

Generally, the term "quantum dot" defines a crystalline material having a size of several nanometers and which is composed of hundreds to thousands of atoms. Due to the small size of these materials, most of the atoms are present on or near the surface of the quantum dots which leads to electronic, optical, chemical and mechanical properties different from those of a bulk crystalline material due to quantum confinement effects.

Each detector element can comprise at least two sub-elements, wherein all sub-elements of a detector element comprise quantum dots of the same average diameter. The use of several sub-elements can at least partially compensate for effects of limited resolution of light falling onto the imaging sensor.

The term "same average diameter" means that the quantum dots within all sub-elements of the detector element have the same average diameter wherein unavoidable variations due to the manufacturing process of the imaging sensor are ignored.

The number of detector elements along the array axis of the array structure is not especially limited, as long as the desired resolution can be achieved. Preferably, the imaging sensor comprises more than two detector elements along the array axis.

The array structure can also be a two-dimensional array structure having a plurality of array axes along each of which several detector elements are arranged, wherein the average diameter of the quantum dots of the detector elements increase along at least one of the plurality of array axes.

The quantum dots can comprise a semiconductive material, the semiconductive material preferably being selected from the group consisting of PbS, PbSe, HgTe, InAs, InSb, CdS, CdSe and combinations thereof, more preferably wherein the semiconductive material of the quantum dots is PbS. Quantum dots of these materials show an absorption maximum at wavelengths typically needed in spectroscopy applications, especially for VIS- and/or NIR-applications. Further, quantum dots of selected sizes can be efficiently prepared from these materials by synthesis routes known in the art.

To improve the conductivity of the quantum dots in the detector element, the quantum dots can have a core-shell structure. Further, using quantum dots with a core-shell structure can improve the robustness and/or lifetime of the imaging sensor.

The core preferably comprises the semiconductive material.

The shell preferably comprises ligands bonded to the core. The ligand can be chosen from the group of carboxylic acids, thioles, amines, organic salts and combinations thereof.

The carboxylic acid is preferably selected from the group of saturated or unsaturated fatty acids having a chain length of from 2 to 22 carbon atoms. E.g., the carboxylic acid can be selected from the group consisting of lauric acid, myristic acid, stearic acid, oleic acid and combinations thereof. Most preferably, the carboxylic acid is oleic acid.

The thiol is preferably selected from the group of saturated or unsaturated thiols having a chain length of from 2 to 8 carbon atoms. Most preferably, the thiol is ethanedithiol, 3-mercaptopropionic acid or a combination thereof.

The amine is preferably selected from the group of saturated and unsaturated amines having a chain length of from 2 to 20 carbon atoms. Most preferably, the amine is butylamine, oleylamine or a combination thereof.

The organic salt preferably is selected from the group of quaternary ammonium salts. Most preferably, the organic salt is a tetrabutylammonium salt, a cetyltrimethyl ammonium salt or a combination thereof, e.g. cetyltrimethyl ammonium bromide.

The additive can be a polymeric compound, the polymeric compound especially being selected from the group of polyvinyl acetates, vinyl lactam polymers and combinations thereof. Preferably, the polymeric compound is polyvinyl butyral (PVB), polyvinylpyrrolydone (PVP) or a combination thereof. More preferably, the polymeric compound is PVB.

The average diameter of the quantum dots can be within the range of from 3 to 20 nm. Quantum dots of this size range show absorption maxima in the VIS- to NIR-range of the light spectrum, thereby rendering these materials especially suitable for VIS- and/or NIR-spectroscopy applications.

Generally, the shape of the quantum dots is not restricted, as long as they show the desired absorption behavior.

In one variant, the quantum dots have a circular or a polygonal shape. The polygonal shape is e.g. a five- or six-sided polygonal shape. The polygonal shape is defined as the contour of the outer edge of the respective quantum dot in a two-dimensional TEM-image.

The imaging sensor especially is an NIR imaging sensor, preferably wherein the imaging sensor is adapted to detect light having a wavelength in a target range of from 500 to 3000 nm, more preferably of from 800 to 2500 nm.

The target range can be achieved based on quantum dots with a bandgap in the range of from about 2.5 to 0.35 eV, preferably of from about 1.6 to 0.52 eV.

The "target range" defines the target spectrum of the imaging sensor.

The imaging sensor can have a responsivity of 1 or more over at least 85% of the target range, preferably over at least 90 % of the target range. In this way, the imaging sensor provides an especially high overall sensitivity.

Due to its excellent responsivity and small size, the imaging sensor is especially suitable for a variety of applications including consumer electronics, augmented reality devices, autonomous driving, space exploration and medical diagnostics.

The object of the invention is further solved by a sensor system comprising the imaging sensor as described above being adapted to detect light from an incident light beam and at least one optical element configured to guide the incident light beam onto the imaging sensor.

The properties and advantages of the imaging sensor according to the invention also apply to the sensor system according to the invention and vice versa and it is referred to the explanations given above.

The at least one optical element especially comprises an optical slit or optical filter and/or a grating. The optical slit or optical filter limits the size and/or intensity of an incoming light beam. The grating is used for generating a dispersed incident light beam which is detected by the imaging sensor.

The pre-determined wavelengths of the quantum dots used in the imaging sensor are especially defined by the resolution of the grating. Termed differently, the grating can determine the available dispersion resolution and the quantum dots in the respective detector elements are chosen such to optimally correspond to the available wavelength resolution. Generally, the resolution of the sensor system is determined by the resolution of the grating, as commercially available gratings typically have a resolution of 5 to 10 nm.

The object of the invention is also solved by a method for manufacturing an imaging sensor comprising a plurality of light-sensitive detector elements being arranged in an array structure, the detector elements comprising quantum dots, the method comprising the steps of:
a) choosing a plurality of pre-determined wavelengths within a target wavelength range,
b) providing a quantum dot precursor having an average diameter corresponding to one of the pre-determined wavelengths,
c) preparing an ink formulation comprising the quantum dot precursor and a solvent, and
d) applying the ink formulation on a substrate, thereby forming one of the plurality of detector elements comprising quantum dots,
wherein steps b) to d) are repeated for each of the pre-determined wavelengths and wherein the ink formulations are applied on the substrate such that the average diameter of the quantum dots in the formed detector elements increases along an array axis of the array structure. The quantum dot precursor further comprises an additive and/or the additive is added during preparation of the ink formulation.

The imaging sensor especially is an imaging sensor as described above.

The method according to the invention provides an easy and reliable way of applying quantum dots of selected sizes having absorption maxima at the pre-determined wavelengths onto the substrate, thereby obtaining an imaging sensor of optimal responsivity and sensitivity. Termed differently, the method according to the invention is based on a combination of using selectively sized quantum dots with a method of additive manufacturing, e.g. inkjet printing of ink formulations comprising quantum dots.

Generally, the method for applying the ink formulation on the substrate is not limited, as long as the respective ink formulation can be reliably applied on the substrate. E.g., the ink formulation can be applied by blade coating, slot die coating, spray coating and/or inkjet printing.

The quantum dot precursor can comprise colloidal quantum dots within a solvent. The colloidal quantum dots can be capped by a ligand such to form a core-shell structure. Quantum dot precursors can be prepared in advance and stored for extended period of times, especially if core-shell structured quantum dots are used. Thus, the necessary quantum dot precursors can be flexibly chosen before the respective manufacturing process at hand.

The solvent can be chosen from the group consisting of N, N-dimethylformamide, hexylamine, butylamine, phenylethylamine, dimethylsulfoxide and combinations thereof.

The solvent used in the ink formulation preferably has a boiling point of 130 °C or less. Solvents or solvent mixtures with a boiling point of 130 °C or less provide a fast solidification of the ink formulation on the substrate after application, thereby reducing the amount of material movement between application of the ink and ink solidification and thus increasing the homogeneity of the formed detector element.

For increasing the density of quantum dots within the detector elements, the quantum dot precursor can have a concentration of at least 300 mg/mL in the ink formulation, preferably of at least 400 mg/mL.

The additive can be a polymeric compound, the polymeric compound especially being selected from the group of polyvinyl acetates, vinyl lactam polymers and combinations thereof. Preferably, the polymeric compound is polyvinyl butyral (PVB), polyvinylpyrrolydone (PVP) or a combination thereofe. More preferably, the polymeric compound is PVB. Thus, the additive can correspond to the additive described before for the film structure of the imaging sensor.

The additive can act as stabilizer in the quantum dot precursor, suppressing aggregation of the quantum dots within the quantum dot precursor thereby increasing shelf life of the quantum dot precursor. Shelf-life can also be improved by the additive due to shielding the quantum dots from environmental factors like oxygen and moisture or reactive chemicals. Without to be bound by theory, these effects are envisaged to be based on by interaction of the additive with the surface of the quantum dots. This interaction also can lead to a more stable colloidal system within the quantum dot precursor, thereby helping to maintain the electronic properties of the quantum dots.

Further, the additive can be used as control aid during quantum dot synthesis to influence the growth dynamics of the quantum dots, resulting in more uniform sizes and shapes of the quantum dots within the quantum dot precursor.

Based on the type and content of additive, the solubility and viscosity of the quantum dot precursor can be altered, increasing the flexibility on how to implement prepare and apply the ink formulation based on the quantum dot precursor such that smooth films can be realized in the detector elements comprising the quantum dots.

The additive can also be added during preparation of the ink formulation.

The substrate can be a finger-structure electrode. Such electrodes lead to an especially easy and fast manufacturing method, as no additional steps other than applying the ink formulation on the finger-structure electrode and drying the ink formulation has to be applied to obtain a functional imaging sensor.

E.g., the detector element can be a photoresistor device.

It is also possible that the substrate comprises a metal oxide layer on which the ink formulation is applied. Thus, the quantum dots will be on top of the metal oxides, forming a multiple layer structure with the substrate.

The kind of substrate is generally not limited, as long as the ink formulation can be homogenously applied on the respective substrate.

Further features and advantages of the invention will become more apparent from the following detailed description of exemplary embodiments, which are not be understood as limiting, the experiments and Figures.
- Fig. 1 schematically shows a sensor system according to the invention comprising an imaging sensor according to the invention,
- Fig. 2 schematically shows the imaging sensor of Fig. 1 in more detail.
- Fig. 3 shows a diagram depicting the responsivity of the imaging sensor of Fig. 1 as a function of wavelength,
- Fig. 4 shows a TEM image of quantum dots used in the imaging sensor of Fig. 1 applied on a substrate,
- Fig. 5 shows a diagram highlighting the size distribution of the quantum dots in Fig. 4,
- Fig. 6 shows an absorption spectrum of one type of quantum dots used in the imaging sensor of Fig. 1,
- Fig. 7 shows a block diagram of a method according to the invention for manufacturing the imaging sensor of Fig. 1,
- Fig. 8 shows confocal microscopy images of PbS nanocrystal films as can be used in the imaging sensor of Fig. 2, and
- Fig. 9 schematically shows another embodiment of the imaging sensor of Fig. 2.

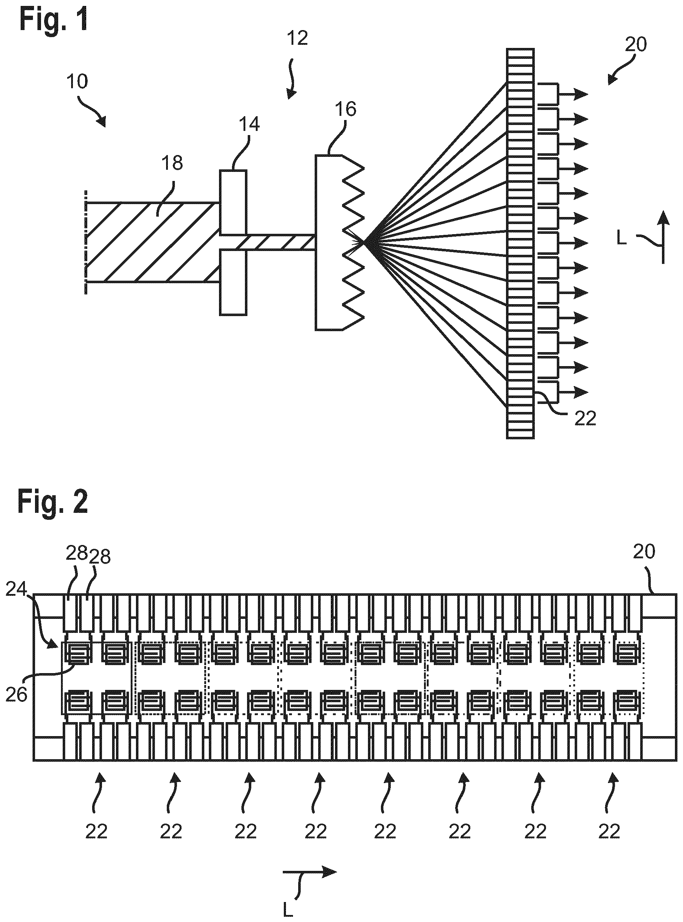

In Fig. 1, a schematic depiction of selected parts of a sensor system 10 according to the invention is shown.

The sensor system 10 comprises several optical elements 12, wherein in the embodiment shown in Fig. 1 the sensor system 10 comprises an optical slit 14 and a grating 16 as optical elements 12.

The optical slit 14 is used to limit the size and of an incoming light beam 18 before said incident light beam 18 falls upon the grating 16. The grating 16 disperses the incident light beam 18. The dispersed incident light beam 18 is then directed onto an imaging sensor 20 according to the invention.

Of course, the kind of optical elements 12, the number of optical elements 12 and their relative arrangement can differ from the exemplary embodiment shown in Fig. 1. E.g., the optical slit 14 can be omitted.

The imaging sensor 20 comprises a plurality of light-sensitive detector elements 22 which are arranged in an array structure along an array axis L of the imaging sensor 20.

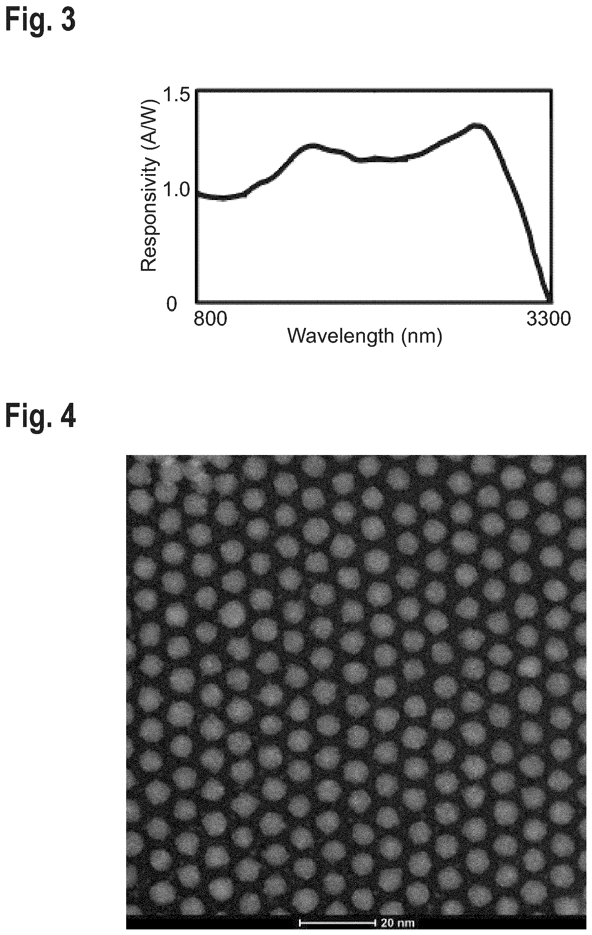

Each of the detector elements 22 comprises quantum dots (see Fig. 4), wherein the size of the quantum dots generally increase along the array axis L. E.g., the average diameter of the quantum dots is within a range of from 3 to 20 nm.

The quantum dots comprise a semiconductive material, the semiconductive material being selected from the group consisting of PbS, PbSe, HgTe, InAs, InSb, CdS, CdSe and combinations thereof.

Due to the different sizes of the quantum dots, the absorption maximum of the respective quantum dots, i.e. the wavelength for which the respective quantum shows the highest responsivity, also changes along the array axis L of the imaging sensor 20.

According to the invention, the average diameter of the quantum dots along the array axis L (and therefore the absorption maxima of the quantum dots) is chosen such that the position of each of the detection elements 22 along the array axis L is matched with the wavelength of the incident light beam 18 after it has been dispersed by the grating 16. Termed differently, each of the detector elements 22 has an absorption maximum at or close to the wavelength of the light which is directed by the grating 16 on the respective detector element 22.

Fig. 2 shows a further schematic depiction of the imaging sensor 20 with more details.

Each of the detector elements 22 comprises a plurality of sub-elements 24, in the shown embodiment a total of four sub-elements 24, as indicated in Fig. 2 by rectangles having differing contours. Of course, each of the detector elements 22 can also comprise a lower or higher number of detector elements 22.

Each of the sub-elements 24 is a finger-structure electrode which acts as a substrate 26 for the quantum dots. The finger-structure electrodes are connected via connection terminals 28 to (not shown) read-out electronics of the imaging sensor 20. Accordingly, a charge built up in the quantum dots on the substrate upon irradiation can be quantified and evaluated.

Within each of the detector elements 22, quantum dots of the same average diameter are applied on the finger-structure electrodes, wherein the average diameter is increasing along the array axis L, such that each of the detector elements 22 has an absorption maximum at a pre-determined wavelength.

E.g., the detector element 22 depicted at the left-hand side of Fig. 2 is the detector element 22 with the smallest quantum dots and therefore with an absorption maximum at the lowest wavelength compared to all other quantum dots used in the imaging sensor. The detector element 22 depicted at the righthand side of Fig. 2 is the detector element 22 with the largest quantum dots and therefore with an absorption maximum at the highest wavelength compared to all other quantum dots used in the imaging sensor.

In Fig. 2, an imaging sensor 20 having a total of eight detector elements 22, each having four sub-elements 24, is shown. Of course, the number of detector elements 22 can be lower or higher than shown in Fig. 2. E.g., the imaging sensor 20 can comprise up to several thousand of detector elements 22.

Preferably, the number of detector elements 22 is matched to the resolution of the grating 16, i.e. the number of detector elements 22, the number of sub-elements 24 within each detector element 22 and/or the spacing between two detector elements 22 is chosen to correspond to the resolution of grating 16.

Fig. 3 shows a diagram depicting the responsivity of an embodiment of the imaging sensor 20 according to the invention as a function of wavelength. As can be seen, the imaging sensor 20 achieves a responsivity of 1.0 or more over most of the spectrum in the range of from 800 to 3300 nm.

For this measurement, a linear array imaging sensor with quantum dots of 18 different average diameters, i.e. having 18 different absorption maxima, has been used, wherein the overall detection range of the imaging sensor was from 400 to 3300 nm.

For determining the power input Pᵢₙ of the used light source as function of wavelength, a calibration measurement was done over the relevant spectrum using a combination of conventional imaging sensors based on silicon, InGaAs and pyroelectric thermodetectors, respectively, to cover the whole target spectrum from visible to the mid-infrared regime. Then, the current output ΔI using the linear imaging sensor with quantum dots was measured as a function of wavelength and the responsivity was calculated according to formula (1) as described above.

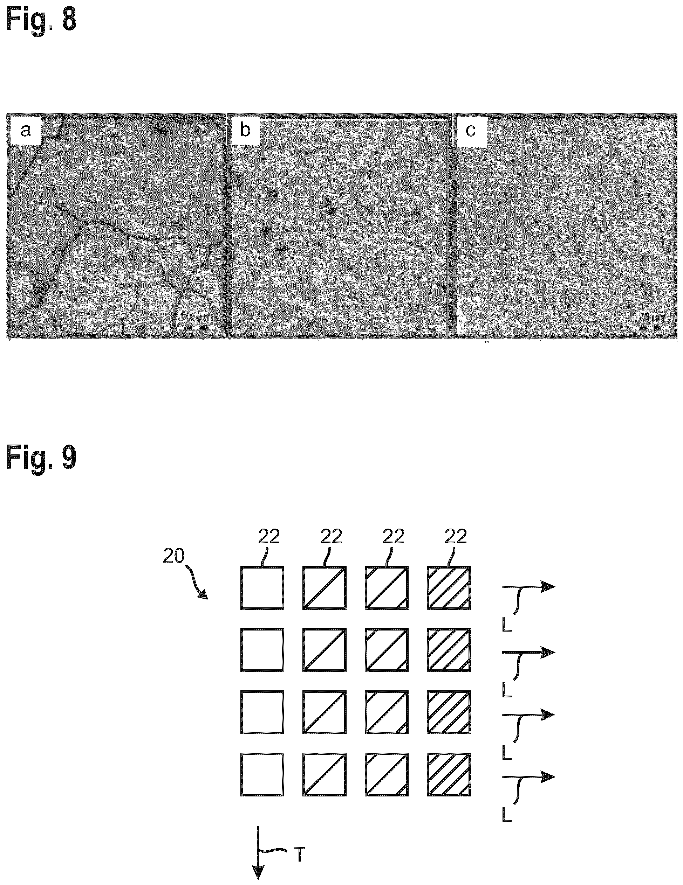

Fig. 9 schematically shows another embodiment of the imaging sensor 20 in which the array structure is arranged in a two-dimensional manner.

Accordingly, the array structure comprises a plurality of array axes L along each of which several detector elements 22 are arranged, wherein the average diameter of quantum dots of the detector elements 22 along any given one of the array axes L increase along said array axis L, as is schematically indicated by the increasing number of lines in Fig. 9.

Along an axis T being perpendicular to each of the array axes L, the average diameter does not increase. However, as the imaging sensor 20 comprises at least one array axis along which the average diameter of the quantum dots increases, an optimal correspondence between the wavelength irradiated on a specific one of the detector elements 22 along the array axis L can be realized.

In the embodiment shown in Fig. 9, a total of four array axes L are present, along each of which four detector elements 22 are arranged. Of course, the number of array axes L and the number of detector elements 22 per array axis L can be different than shown in Fig. 9.

In the following, a method for manufacturing the image sensor as described above is presented.

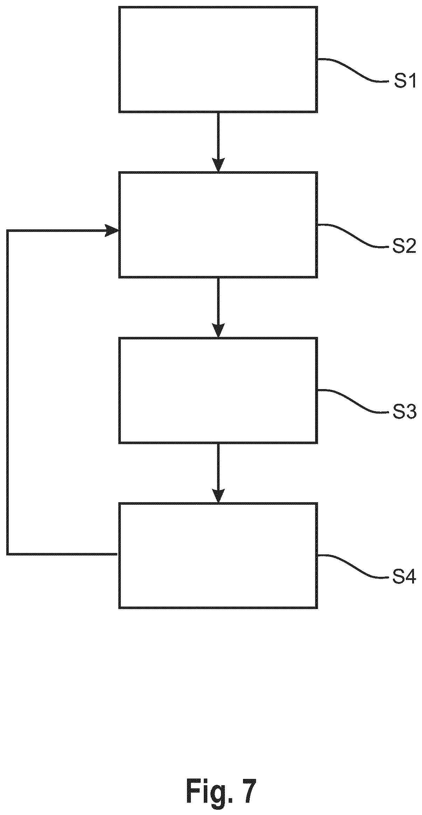

First, as step a), a plurality of pre-determined wavelengths within a target wavelength range is chosen (see step S1 in Fig. 7). The target wavelength range is determined based on the intended application of the imaging sensor 20.

E.g., the imaging sensor 20 is an NIR imaging sensor which is supposed to detect light having a wavelength in a target range of from 500 to 3000 nm. Thus, the pre-determined wavelengths need to be chosen within said target range, preferably equally spaced within the target range.

Second, as step b), a quantum dot precursor having an average diameter corresponding to one of the pre-determined wavelengths is provided (see step S2 in Fig. 7). Preparation methods for quantum dot precursors are known in the art. One example for preparing a quantum dot precursor will be described later.

As step c), an ink formulation comprising the quantum dot precursor and a solvent is prepared (see step S3 in Fig. 7).

The solvent is especially chosen from the group consisting of N,N-dimethylformamide (DMF), hexylamine (HEX), butylamine (BTA), phenylethylamine (PEA), dimethylsulfoxide (DMSP) and combinations thereof.

Finally, as step d), the ink formulation is applied on the substrate 26, i.e. on the finger-structure electrodes 24 of one of the detector elements 22 in the shown embodiment, thereby forming one of the plurality of detector elements 22 (see step S4 in Fig. 7).

Steps b) to d) are then repeated for each of the pre-determined wavelengths to form all of the detector elements 22, such that the average diameter of the quantum dots increase along the array axis L of the array structure.

Of course, the iteration of steps b) to d) can also be done in an interleaved manner. E.g., at least some of the ink formulations can already be prepared when one of the ink formulation is currently already applied on the substrate.

### Experiments

### Synthesis of quantum dots

For the synthesis of PbS quantum dots with an absorption edge at about 1700 nm, a 250 mL three-neck flask is filled with 900 mg (4 mmol) PbO and 30.35 mL (95 mmol) 1-octadecene inside of a nitrogen filled glovebox. Afterwards, the flask is mounted onto a Schlenk line, evacuated and flushed with nitrogen for three times. Under nitrogen flow, 37.8 g (144 mmol) oleic acid is added. The solution is heated to 150°C under vacuum for one hour. During this time, the solution is degassed and the yellow color disappeared, meaning that the lead oleate precursor is formed.

Afterwards, the solution is cooled to 120°C under a nitrogen atmosphere. The sulfur precursor solution, consisting of 420 µL (2 mmol) bis-(trimethylsilyl)-sulfide (TMS-S) in 5.0 mL (15.6 mmol) 1-octadecene, is injected into the lead oleate precursor solution and the reaction was stirred for exactly 5 minutes, then quenched in an ice bath for at least 2.5 minutes.

For purification, the solution is loaded into four centrifuge tubes. The quantum dots (QDs) in each tube are precipitated with 10 mL ethanol and 10 mL acetone, followed by centrifugation (7860 rpm, 10 minutes) and discarding the supernatant. The washing process was repeated twice by redispersing the sediment in 15 mL octane using the vortex and precipitating the PbS quantum dots with 10 mL ethanol and 10 mL acetone, followed by centrifugation (7860 rpm, 10 minutes) and removing the supernatant.

The PbS quantum dots in the sediment are dried in vacuum and redispersed in toluene at a concentration of 40 mg/mL for long-term storage.

For the synthesis of PbS quantum dots with an absorption edge at about 950 nm for the HTL, minor changes during the synthesis method described above are employed.

900 mg PbO are dissolved in 52.5 mL 1-octadecene and 3.2 mL oleic acid is used as the ligand. The sulfur precursor solution was not changed, i.e. 420 µL TSM-S in 5 mL 1-octadecene. During the injection, the temperature was lowered to 100°C. All other steps are kept the same as described above.

From the above, it is clear that the same procedure can be followed for obtaining PbS quantum dots of a target size having an absorption maximum at a pre-determined wavelength.

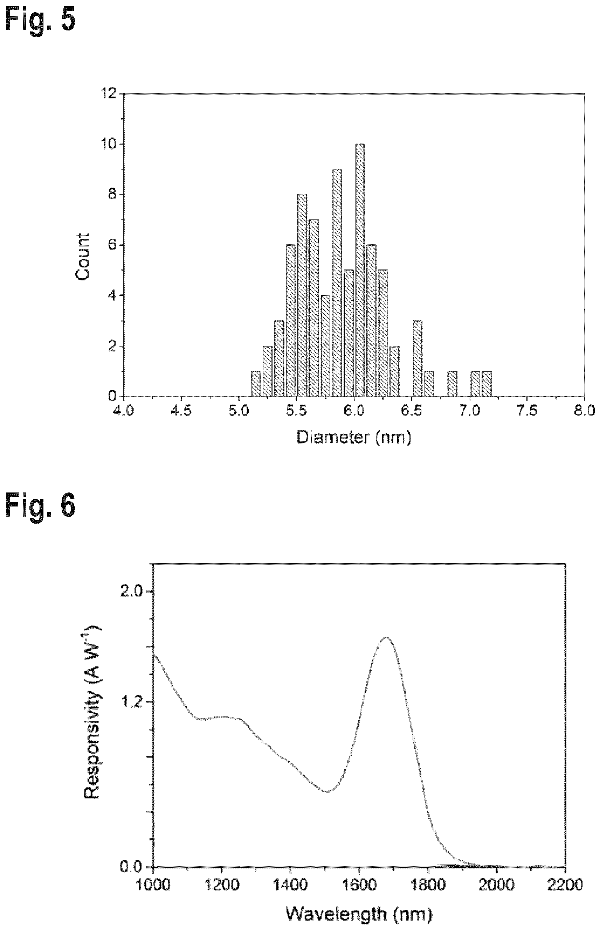

Fig. 4 shows a TEM image of oleate-capped PbS quantum dots with an absorption edge of 1710 nm and Fig. 5 a histogram of a representative region from the TEM image comprising a total of 75 quantum dots with an average diameter of 5.91 ± 0.41 nm.

From these Figures, it becomes evident that PbS quantum dots can be synthesized such to obtain a precise size control of the synthesized quantum dots.

### Synthesis of core-shell quantum dots

The synthesized oleate-capped PbS quantum dots in toluene are precipitated with acetone, dried and dissolved in octane at a concentration of 60 mg/mL. Furthermore, 922 mg (2 mmol) PbI₂, 146.8 mg (0.5 mmol) PbBr₂ and 72.2 mg (0.88 mmol) sodium acetate are dissolved in 20 mL DMF as ligand precursor solution.

Two centrifuge tubes are loaded with 30 mL octane, 1 mL of the oleate-capped PbS in octane and 10 mL of the ligand precursor solution each. The tube is shaken for 30 s by hand, centrifuged (7860 rpm, 30 sec) and the octane phase is removed.

During this step, the octane phase became clear and the quantum dots moved into the polar DMF phase. To remove all organic ligand impurities, the DMF phase is washed three times. Each step consisted of the addition of 10 mL octane, shaking for 30 seconds, centrifugation and final removal of the octane phase. In the last step, all solvents, i.e. the octane and DMF phase, are removed.

The quantum dots are partially redispersed in 250 µL DMF by vortexing. For full dissolution, 10 µL of BTA is added. The solution of both tubes is moved into a single 2 mL centrifuge tube, in which the quantum dots are precipitated with 800 µL toluene and centrifuged at 13.000 rpm for 3 minutes.

Afterwards, the PbS quantum dots are dissolved in 500 µL DMF and 10 µL BTA, precipitated with 1 mL toluene and centrifuged at 13.000 rpm for 5 minutes.

### Ink formulation and application

The pellet obtained from synthesis of core-shell quantum dots is moved into a glass vial and an ink is prepared by adding a suitable solvent.

Possible solvent mixtures include DMF:DMSP:BTA:PEA and HEX:DMF:BTA.

An ink consisting of DMF:HEX:BTA in the ratio of 1:1:1 (v/v) has an approximate boiling point of 120°C which ensures a fast film solidification.

The concentration for the thin film fabrication is 450 mg/mL.

The ink can be directly applied onto the substrate and the solvent be evaporated to form the quantum dots on the substrate.

To remove further remaining particles, the ink can be centrifuged exactly 30 s and the supernatant is used for the application of the ink, e.g. by blade coating.

### Photoconductivity experiments

Photoconductivity experiments were done with a tungsten lamp used as illumination source which was mono-achromatized by a grating spectrometer ("Acton SP 2150" from "Princeton" company). The output tuned light obtained from the grating spectrometer was modulated with a mechanical chopper. On the sample side, the detector was biased with a "Keithley 236 SMU" source measure unit. The output current was read through a "Signal Recovery 7265 DSP" lock-in amplifier.

Fig. 6 shows an exemplary responsivity graph as a function of wavelength for a detector element having quantum dots with an absorption maximum at 1650 nm.

### Preparation of film structures

Figs. 8a to 8c show confocal microscopy images of PbS nanocrystal films obtained by applying an ink formulation comprising PbS quantum dots and a solvent (Fig. 8a) or a solvent mixture (Figs. 8b and 8c) on a substrate, wherein in the ink formulations used for preparing the films of Figs 8b and 8c also polyvinyl butyral (PVB) has been used in the ink formulation as additive.

In the ink formulation used to obtain Fig. 8a, N,N-dimethylformamide (DMF) has been used as solvent.

The ink formulation used to obtain Fig. 8b has used a binary solvent mixture consisting of N,N-dimethylformamide (DMF) and hexylamine (HEX), while the ink formulation used to obtain Fig. 8c has used a ternary solvent mixture consisting of N,N-dimethylformamide (DMF), hexylamine (HEX), and butylamine (BTA).

In Fig. 8a, a rough surface structure and cracks within the film can be observed. By using a solvent mixture instead of a single solvent and an additive, crack formation can be efficiently suppressed and surface smoothness can be improved, as highlighted by Figs.8b and 8c, respectively.

Surface roughness S_{g} has been determined according to ISO 25178 and reduces from 80 nm (Fig. 8a) over 55 nm (Fig. 8b) to 8 nm (Fig. 8c).

## Claims

1. An imaging sensor (20) comprising a plurality of light-sensitive detector elements (22) being arranged in an array structure, the detector elements (22) comprising quantum dots,
wherein the average diameter of the quantum dots of the detector elements (22) increase along an array axis of the array structure such that each of the detector elements (22) along the array axis has an absorption maximum at a different pre-determined wavelength, and
wherein the quantum dots of a given detector element (22) are part of a film structure of the given detector element (22) comprising the quantum dots and an additive.

2. The imaging sensor (20) according to claim 1, wherein each detector element (20) comprises at least two sub-elements (24), wherein all sub-elements (24) of a detector element (22) comprise quantum dots of the same average diameter.

3. The imaging sensor (20) according to claim 1 or 2, wherein the quantum dots comprise a semiconductive material, the semiconductive material preferably being selected from the group consisting of PbS, PbSe, HgTe, InAs, InSb, CdS, CdSe and combinations thereof, more preferably wherein the semiconductive material of the quantum dots is PbS.

4. The imaging sensor (20) according to any of the preceding claims, wherein the quantum dots have a core-shell structure.

5. The imaging sensor (20) according to any of the preceding claims, wherein the average diameter of the quantum dots is within the range of from 3 to 20 nm.

6. The imaging sensor (20) according to any of the preceding claims, wherein the quantum dots have a circular or polygonal shape.

7. The imaging sensor (20) according to any of the preceding claims, wherein the imaging sensor (20) is an NIR imaging sensor, especially wherein the imaging sensor (20) is adapted to detect light having a wavelength in a target range of from 500 to 3000 nm, preferably of from 800 to 2500 nm, especially wherein the imaging sensor (20) has a responsivity of 1 or more over at least 85% of the target range, preferably over at least 90 % of the target range.

8. The imaging sensor (20) according to any of the preceding claims, wherein the additive is a polymeric compound, the polymeric compound especially being selected from the group of polyvinyl acetates, vinyl lactam polymers and combinations thereof, preferably being polyvinyl butyral, polyvinylpyrrolydone or a combination thereof, more preferably being polyvinyl butyral.

9. A sensor system (10) comprising the imaging sensor (20) according to any of the preceding claims being adapted to detect light from an incident light beam (18) and at least one optical element (12) configured to guide the incident light (18) beam onto the imaging sensor (20).

10. A method for manufacturing an imaging sensor (20) comprising a plurality of light-sensitive detector elements (22) being arranged in an array structure, the detector elements (22) comprising quantum dots, the method comprising the steps of:
a) choosing a plurality of pre-determined wavelengths within a target wavelength range,
b) providing a quantum dot precursor having an average diameter corresponding to one of the pre-determined wavelengths,
c) preparing an ink formulation comprising the quantum dot precursor and a solvent, and
d) applying the ink formulation on a substrate (26), thereby forming one of the plurality of detector elements (22) comprising quantum dots,
wherein steps b) to d) are repeated for each of the pre-determined wavelengths and wherein the ink formulations are applied on the substrate (26) such that the average diameter of the quantum dots in the formed detector elements (22) increases along an array axis of the array structure, and
wherein the quantum dot precursor further comprises an additive and/or wherein the additive is added during preparation of the ink formulation.

11. The method of claim 10, wherein the solvent is chosen from the group consisting of N,N-dimethylformamide, hexylamine, butylamine, phenylethylamine, dimethylsulfoxide and combinations thereof.

12. The method of claim 10 or 11, wherein the solvent used in the ink formulation has a boiling point of 130 °C or less.

13. The method of any of claims 10 to 12, wherein the quantum dot precursor has a concentration of at least 300 mg/mL in the ink formulation, preferably of at least 400 mg/mL.

14. The method of any of claims 10 to 13, wherein the substrate (26) is a finger-structure electrode.

15. The method of any of claims 10 to 14, wherein the substrate (26) comprises a metal oxide layer on which the ink formulation is applied.

## Patentansprüche

1. Bildsensor (20) mit mehreren lichtempfindlichen Detektorelementen (22), die in einer Array-Struktur angeordnet sind, wobei die Detektorelemente (22) Quantenpunkte umfassen,
wobei der mittlere Durchmesser der Quantenpunkte der Detektorelemente (22) längs einer Array-Achse der Array-Struktur derart zunimmt, dass jedes der Detektorelemente (22) längs der Array-Achse ein Absorptionsmaximum bei einer anderen vorbestimmten Wellenlänge hat, und
wobei die Quantenpunkte eines bestimmten Detektorelements (22) Teil einer Filmstruktur des bestimmten Detektorelements (22) sind, die die Quantenpunkte und ein Additiv umfasst.

2. Bildsensor (20) nach Anspruch 1, wobei jedes Detektorelement (20) mindestens zwei Unterelemente (24) umfasst, wobei alle Unterelemente (24) eines Detektorelements (22) Quantenpunkte mit demselben mittleren Durchmesser umfassen.

3. Bildsensor (20) nach Anspruch 1 oder 2, wobei die Quantenpunkte ein halbleitendes Material umfassen, wobei das halbleitende Material vorzugsweise aus der Gruppe ausgewählt ist, die aus PbS, PbSe, HgTe, InAs, InSb, CdS, CdSe und Kombinationen davon besteht, und wobei es sich bei dem halbleitenden Material der Quantenpunkte weiter vorzugsweise um PbS handelt.

4. Bildsensor (20) nach einem der vorhergehenden Ansprüche, wobei die Quantenpunkte eine Kern-Schale-Struktur aufweisen.

5. Bildsensor (20) nach einem der vorhergehenden Ansprüche, wobei der mittlere Durchmesser der Quantenpunkte im Bereich von 3 bis 20 nm liegt.

6. Bildsensor (20) nach einem der vorhergehenden Ansprüche, wobei die Quantenpunkte eine kreisförmige oder polygonale Form haben.

7. Bildsensor (20) nach einem der vorhergehenden Ansprüche, wobei der Bildsensor (20) ein NIR-Bildsensor ist, insbesondere wobei der Bildsensor (20) dazu ausgelegt ist, Licht mit einer Wellenlänge in einem Zielbereich von 500 bis 3000 nm, vorzugsweise von 800 bis 2500 nm, zu erfassen, insbesondere wobei der Bildsensor (20) über mindestens 85 % des Zielbereichs, vorzugsweise über mindestens 90 % des Zielbereichs eine Empfindlichkeit von 1 oder mehr hat.

8. Bildsensor (20) nach einem der vorhergehenden Ansprüche, wobei das Additiv eine polymere Verbindung ist, wobei die polymere Verbindung insbesondere aus der Gruppe der Polyvinylacetate, Vinyl-Lactam-Polymere und Kombinationen davon ausgewählt ist, vorzugsweise Polyvinylbutyral, Polyvinylpyrrolidon oder eine Kombination davon ist, weiter vorzugsweise Polyvinylbutyral ist.

9. Sensorsystem (10) mit dem Bildsensor (20) nach einem der vorhergehenden Ansprüche, der dazu ausgelegt ist, Licht eines einfallenden Lichtstrahls (18) zu erfassen, und mindestens einem optischen Element (12), das so ausgebildet ist, dass es den einfallenden Lichtstrahl (18) auf den Bildsensor (20) lenkt.

10. Verfahren zur Herstellung eines Bildsensors (20), der mehrere lichtempfindliche Detektorelemente (22) umfasst, die in einer Array-Struktur angeordnet sind, wobei die Detektorelemente (22) Quantenpunkte umfassen, wobei das Verfahren folgende Schritte umfasst:
a) Auswählen mehrerer vorbestimmter Wellenlängen innerhalb eines Zielwellenlängenbereichs,
b) Bereitstellen eines Quantenpunkt-Vorläufers mit einem mittleren Durchmesser, der einer der vorbestimmten Wellenlängen entspricht,
c) Herstellen einer Tintenformulierung, die den Quantenpunkt-Vorläufer und ein Lösungsmittel umfasst, und
d) Aufbringen der Tintenformulierung auf ein Substrat (26), wodurch eines der mehreren Detektorelemente (22), das Quantenpunkte umfasst, gebildet wird,
wobei die Schritte b) bis d) für jede der vorbestimmten Wellenlängen wiederholt werden und die Tintenformulierungen so auf das Substrat (26) aufgebracht werden, dass der mittlere Durchmesser der Quantenpunkte in den gebildeten Detektorelementen (22) längs einer Array-Achse der Array-Struktur zunimmt, und
wobei der Quantenpunkt-Vorläufer ferner ein Additiv umfasst und/oder wobei das Additiv während der Herstellung der Tintenformulierung zugegeben wird.

11. Verfahren nach Anspruch 10, wobei das Lösungsmittel aus der Gruppe ausgewählt ist, die aus N,N-Dimethylformamid, Hexylamin, Butylamin, Phenylethylamin, Dimethylsulfoxid und Kombinationen davon besteht.

12. Verfahren nach Anspruch 10 oder 11, wobei das in der Tintenformulierung verwendete Lösungsmittel einen Siedepunkt von 130 °C oder weniger hat.

13. Verfahren nach einem der Ansprüche 10 bis 12, wobei der Quantenpunkt-Vorläufer in der Tintenformulierung eine Konzentration von mindestens 300 mg/mL hat, vorzugsweise von mindestens 400 mg/mL.

14. Verfahren nach einem der Ansprüche 10 bis 13, wobei es sich bei dem Substrat (26) um eine Fingerstrukturelektrode handelt.

15. Verfahren nach einem der Ansprüche 10 bis 14, wobei das Substrat (26) eine Metalloxidschicht umfasst, auf die die Tintenformulierung aufgebracht wird.

## Revendications

1. Capteur d'image (20) comprenant une pluralité d'éléments détecteurs photosensibles (22) agencés selon une structure en réseau, les éléments détecteurs (22) comprenant des points quantiques,
le diamètre moyen des points quantiques des éléments détecteurs (22) augmentant le long d'un axe de réseau de la structure en réseau, de sorte que chacun des éléments détecteurs (22) le long de l'axe de réseau présente un maximum d'absorption à une longueur d'onde prédéterminée différente, et
les points quantiques d'un élément détecteur donné (22) faisant partie d'une structure en film de l'élément détecteur donné (22) comprenant les points quantiques et un additif.

2. Capteur d'image (20) selon la revendication 1, chaque élément détecteur (20) comprenant au moins deux sous-éléments (24), tous les sous-éléments (24) d'un élément détecteur (22) comprenant des points quantiques de même diamètre moyen.

3. Capteur d'image (20) selon la revendication 1 ou 2, les points quantiques comprenant un matériau semi-conducteur, le matériau semi-conducteur étant de préférence choisi dans le groupe constitué de PbS, PbSe, HgTe, InAs, InSb, CdS, CdSe et leurs combinaisons, le matériau semi-conducteur des points quantiques étant plus préférablement du PbS.

4. Capteur d'image (20) selon l'une quelconque des revendications précédentes, les points quantiques présentant une structure cœur-coquille.

5. Capteur d'image (20) selon l'une quelconque des revendications précédentes, le diamètre moyen des points quantiques étant compris dans la plage de 3 à 20 nm.

6. Capteur d'image (20) selon l'une quelconque des revendications précédentes, les points quantiques présentant une forme circulaire ou polygonale.

7. Capteur d'image (20) selon l'une quelconque des revendications précédentes, le capteur d'image (20) étant un capteur d'image NIR, le capteur d'image (20) étant en particulier apte à détecter la lumière présentant une longueur d'onde comprise dans une plage cible de 500 à 3000 nm, de préférence de 800 à 2500 nm, le capteur d'image (20) présentant en particulier une responsivité égale ou supérieure à 1 sur au moins 85 % de la plage cible, de préférence sur au moins 90 % de la plage cible.

8. Capteur d'image (20) selon l'une quelconque des revendications précédentes, l'additif étant un composé polymère, le composé polymère étant notamment choisi dans le groupe des acétates de polyvinyle, des polymères de lactame vinylique et de leurs combinaisons, étant de préférence du polybutyral de vinyle, de la polyvinylpyrrolidone ou une combinaison de ceux-ci, plus préférablement du polybutyral de vinyle.

9. Système de capteurs (10) comprenant le capteur d'image (20) selon l'une quelconque des revendications précédentes, lequel est apte à détecter la lumière provenant d'un faisceau lumineux incident (18), et au moins un élément optique (12) réalisé de manière à guider le faisceau lumineux incident (18) sur le capteur d'image (20).

10. Procédé de fabrication d'un capteur d'image (20) comprenant une pluralité d'éléments détecteurs photosensibles (22) agencés selon une structure en réseau, les éléments détecteurs (22) comprenant des points quantiques, le procédé comprenant les étapes consistant :
a) à choisir une pluralité de longueurs d'onde prédéterminées dans une plage de longueurs d'onde cible,
b) à fournir un précurseur de points quantiques présentant un diamètre moyen correspondant à l'une des longueurs d'onde prédéterminées,
c) à préparer une formulation d'encre comprenant le précurseur de points quantiques et un solvant, et
d) à appliquer la formulation d'encre sur un substrat (26), formant ainsi l'un des plusieurs éléments détecteurs (22) comprenant des points quantiques,
les étapes b) à d) étant répétées pour chacune des longueurs d'onde prédéterminées, et les formulations d'encre étant appliquées sur le substrat (26) de sorte que le diamètre moyen des points quantiques dans les éléments détecteurs (22) formés augmente le long d'un axe de réseau de la structure en réseau, et
le précurseur de points quantiques comprenant en outre un additif, et/ou l'additif étant ajouté lors de la préparation de la formulation d'encre.

11. Procédé selon la revendication 10, le solvant étant choisi dans le groupe constitué de N,N-diméthylformamide, d'hexylamine, de butylamine, de phényléthylamine, de diméthylsulfoxyde et de leurs combinaisons.

12. Procédé selon la revendication 10 ou 11, le solvant utilisé dans la formulation d'encre présentant un point d'ébullition égal ou inférieur à 130 °C.

13. Procédé selon l'une quelconque des revendications 10 à 12, le précurseur de points quantiques présentant une concentration d'au moins 300 mg/mL dans la formulation d'encre, de préférence d'au moins 400 mg/mL.

14. Procédé selon l'une quelconque des revendications 10 à 13, le substrat (26) étant une électrode à structure en doigt.

15. Procédé selon l'une quelconque des revendications 10 à 14, le substrat (26) comprenant une couche d'oxyde métallique sur laquelle la formulation d'encre est appliquée.
